# EUROPEAN PATENT APPLICATION

(11) **EP 0 691 419 A1**
(43) Date of publication of application: **10.01.1996**
(21) Application number: 95303594.6
(22) Date of filing: 26.05.1995
(51) Int. Cl.: C23C 14/35, C23C 14/06, C23C 14/08

(54) **A process and apparatus for forming multi-layer optical films**

(30) Priority: 05.07.1994 US 270544
(71) Applicant: GENERAL ELECTRIC COMPANY, Schenectady, NY 12345 (US)
(72) Inventor: Sproul, William D., Palatine, Illinois 60067 (US); Parham, Thomas Gene, Gates Mills, Ohio 44040 (US); Maxwell, Randolph E., Chesterland, Ohio 44026 (US); Graham, Michael Evans, Evanston, Illinois 60201 (US); Bergman, Rolf Sverre, Cleveland Heights, Ohio 44118 (US)
(74) Representative: Pratt, Richard Wilson

(57) **Abstract**

A process for forming multi-layer optical quality films by sputtering at least a first and second material with at least two unbalanced DC magnetron sputtering devices. During sputtering, an effective negative radio frequency or alternating current bias is applied to the substrate and an arc suppression device is operated to reduce arcing on the sputtering devices. In addition, a controlled partial pressure of a reactive gas is maintained in the sputtering chamber to provide a sufficient amount of reactive gas to form the desired compound on the substrate without substantially poisoning the target.

## Description

### Background of the Invention

### Field of the Invention

This invention relates to a process and the related apparatus for forming multi-layer optical quality films. More particularly, this invention relates to a process and the related apparatus for unbalanced reactive DC magnetron sputtering of multi-layered, high performance infrared (IR) reflecting optical interference films. The process of the current invention is particularly well suited to forming infrared reflecting multi-layer optical films on lamp envelopes. Throughout the specification, numerous references will be made to the use of the process for forming multi-layer oxide films on lamps. However, it should be realized that the invention can be used to coat optical quality multi-layer films comprised of various dielectric materials on a variety of lamps and other surfaces. In addition, although the specification is directed to primarily IR reflecting films, one of ordinary skill in the art will immediately recognize the invention's applicability to other coatings such as visible reflecting films, and ultra violet reflecting films.

### Description of the Art

Currently, multi-layer films for use in optical applications are prepared by a number of processes including chemical vapor deposition (CVD), physical evaporation, and sputtering. Nonetheless, each of these methods has certain shortcomings which prohibit or at least limit their application to high performance optical coatings, particularly infrared reflecting lamp coatings.

The CVD process has demonstrated a commercially viable rate of deposition and produces films with acceptable characteristics for high performance IR coatings. However, CVD deposited films are limited in thickness, i.e. number of layers, by the tensile stress added by each additional layer. Accordingly, tensile stress limits IR reflecting multilayer CVD films to a maximum thickness of approximately four microns. Films in excess of about four microns have been found to exhibit shrinkage, cracking, lifting and loss of infrared reflectance, especially during annealing and high temperature operation. One appeal of the current process is its ability to form many layers while reducing tensile stress. Therefore, the subject films are less susceptible to cracking, lifting or fracture.

U.S. Patent No. 5,138,219, herein incorporated by reference, describes a CVD or low pressure CVD process for forming an interference coating with a thickness of about four microns containing about 50 layers. These films are claimed to transmit at least 90 percent of the visible light and reflect at least 70 percent of the IR between 800 and 1900 nm. While films with total thickness of about four microns have acceptable optical properties, it is desirable to increase the thickness further to improve the film's IR reflection capability. This usually implies an increase in the number of layers.

The subject invention is directed to a process for making coatings having at least the capabilities of the films described in U.S. Patent No. 5,138,219. In fact, the coating prepared by the present invention will preferably have a greater number of layers, and accordingly, superior properties in comparison to CVD films. Therefore, the coatings of the subject invention will possess at least about 90 percent transmittance and preferably 98 percent transmittance in a wavelength range of about 400 to 750nm and at least about 70 percent average reflectance in the IR wavelength range of about 750 to 2000 nm.

In addition to the CVD technique, several reactive sputtering processes to coat multi-layer films have been developed, and reactive sputtering has become a popular means for producing eye glass and window glass (predominately flat) coatings on an industrial scale. However, the stringent demands on high performance IR reflecting optical coatings have heretofore prohibited the development of a commercially viable sputtering process for their production.

There are many requirements in a reactive sputtering process necessary to form quality films. For example, it is desirable to have metal atoms and reactive gas atoms react at the substrate in stoichiometric amounts. If the respective atom arrival rates at the substrate are not balanced, the film will not have the expected composition. In addition, an overabundance of reactive oxygen, required for oxide films, leads to oxidation of the target resulting in degradation to the overall process and particularly the sputtering rates. Since sputtering is generally performed in close proximity to the target, within the magnetic field which contains the plasma, the reactive gas in this region leads to rapid poisoning and/or compound formation on the target.

To alleviate these problems, the process described in U.S. Patent 4,420,385 (to Hartsough) rotates the substrate from a shielded sputtering zone to a reaction zone in which a reactive gas is pumped. The reactive gas and the sputtering zone are therefore separated. Alternatively, U.S. Patent 4,851,095 (to Ecobey, et al.) teaches DC magnetron reactive sputtering in a physically isolated zone and utilizes an ion gun to create a high energy reactive gas isolated from the target. It is believed, however, that each of these processes suffer from a lack of sufficient ion bombardment at the substrate surface to obtain satisfactory optical film performance. Further, the step-wise process of laying a metal layer followed by reacting it in an isolated zone limits the thickness of the metal layer which can be deposited and still completely react with the reactive gas.

In addition to the problems associated with controlling the reactive gas, we have found that the prior sputtering processes do not impart sufficient energy to the growing multi-layer films resulting in columnar growth and a film waviness which is exaggerated with each successive layer. The waviness severely degrades the performance of the multi-layer coating, diminishing its usefulness in high performance optical applications. We have found that wavy films demonstrate low reflectivity and other poor characteristics making them undesirable for high performance applications. For example, lamps with multilayer films made with currently available sputtering equipment showed only about 75 percent of the luminous efficacy of identical film designs made with the low pressure CVD technique. This implies that the IR reflection in the 800 to 1900 nm wavelength region is on average 10 to 15 percent less than films made using low pressure CVD. This problem is exacerbated in a conventional sputtering process because the substrate holder is rotated. Only extremely low energy sputtering with low deposition rates has heretofore avoided columnar growth, but this method is unsatisfactory from a commercial productivity standpoint. Accordingly, the art is in need of a reactive sputtering process for depositing satisfactory high performance IR reflecting optical quality multi-layer films.

### Summary of the Invention

It is a primary object of this invention to provide a new and improved process and the related apparatus for depositing multi-layer high performance optical films.

It is a still further object of this invention to provide a new and improved unbalanced DC magnetron sputtering process for depositing high performance optical quality IR reflecting multi-layer films for lamps and other objects having a curved surface.

Additional objects and advantages of the invention will be set forth in part in the description which follows and in part will be obvious from the description, or may be learned by practice of the invention. The objects and advantages of the invention may be realized and obtained by means of the instrumentalities and combinations particularly pointed out in the appended claims.

To achieve the foregoing objects in accordance with the purpose of the invention as embodied and broadly described herein, the process of this invention comprises placing a substrate in a vacuum chamber having an atmosphere comprised of an inert gas and a controlled partial pressure of a reactive gas. An unbalanced DC magnetron is employed to reactively sputter a layer of a first dielectric material onto the substrate. When at least two material multi-layer films are being deposited, a second DC magnetron is used to sputter a second material onto the substrate. Multiple layers are deposited on the substrate until a multi-layer optical quality film of desired thickness is formed. Preferably, material layers are deposited at the rate of at least 1 Angstrom per second, and more preferably at least 10 to 20 Angstroms per second. Optionally, additional DC magnetrons may be utilized to deposit the same materials as in the first and/or second magnetrons or different materials. Accordingly, multi-layer films of several different materials can be formed. A particularly preferred film would include tantala and silica layers.

During sputtering, the reactive gas content in the chamber is controlled to provide at least a sufficient quantity of rective gas in the film deposition area to maintain a stoichiometric reaction with the dielectric material being deposited while controlling the upper limit of reactive gas to prevent unnecessary and significant poisoning of the target.

During sputtering, a negative electrical bias is applied to the substrate. The bias functions to attract increased ion flow to impact the substrate, elevating the energy applied thereto. Although not wishing to be bound by theory, we believe it is this increased energy which promotes mobility and resputtering of the depositing surfaced atoms and has the effect of reducing waviness of the film surface, i.e., planarizing the surface and contributing to the densification by filling the voids between the deposited grains.

For electrically conductive coatings deposited on electrically conducting substrates a DC bias can be applied to the substrate. However, for deposition of electrically insulating coatings, particularly on electrically insulating substrates, either RF bias or bi-polar DC bias must be used to obtain a negative bias potential to accelerate the ions. Experimentally it has been found that a plasma of an RF or high frequency bi-polar DC discharge develops an appreciable potential which is positive with respect to both the anode which is at ground potential, and the substrate. This potential is a consequence of the significantly higher mobility of the electrons as compared to the ions. As a result many more electrons than ions reach the electrodes or substrate during a half cycle. Since, in equilibrium, to maintain electrical neutrality, equal numbers of ions and electrons must reach the substrate surface, a negative potential between the substrate and plasma is set up. Thus, ions falling to the substrate surface through this RF or bi-polar pulsed DC bias potential gain significant energy which is imparted to the surface. It should be understood that this negative bias of the substrate with respect to the plasma is created only when the frequency of the RF or bi-polar pulsed DC source is such that electrons can migrate quite far along the electric field as compared to the ions. This condition is true for frequencies in the high kilo hertz and megahertz range. Accordingly, an effective negative bias is not created either at low frequencies or at ultrahigh frequencies such as in microwave discharges.

We have found that the energy of the ions impinging on the surface must be above a minimum value to create high quality optical films. Further, we have found that a negative bias of at least minus 50 volts, preferably minus 60 volts, more preferably minus 100 volts, measured with respect to the anode or ground potential, is needed to achieve sufficient ion energy at the surface of the substrate to rearrange the film while it is depositing, thus tending to planarize the film surface and densify the film. However, the most significant minimum minus voltage requirement is one sufficient to produce a film wherein peaks and valleys in the individual layer surfaces, if present within 500 Angstrom of one another, have a variation from a plane drawn parallel to the average of the peaks to a plane drawn parallel to the average of the valleys of less than about 100 Angstrom.

It should be noted that the actual negative bias potential between the substrate and plasma is not usually equal to that of the negative potential between the anode and the plasma. The electrically insulating substrate will be at a different potential, called the floating potential. The magnitude of the floating potential depends on the plasma configuration and discharge parameters. For a balanced or mirrored magnetron plasma the difference between the floating and anode potential is on the order of a few volts, usually negative. However, in an unbalanced magnetron the magnetic trapping of the electrons tends to increase their density at the insulating substrate, thus creating a floating potential which is significantly more negative. The magnitude of the floating potential, measured in our apparatus is between minus 20 to minus 30 volts, depending on the amount of unbalance, the magnetron power and the substrate surface area. Thus it should be understood that if sputtering conditions change, the optimum bias voltage may change to some extent to assure that the ions must have sufficient energy to planarize the surface and densify the film without being so energetic as to damage the film being deposited.

In a preferred embodiment, RF power is applied to the substrate holder through an impedance matching network whereas in the case of a bi-polar pulsed DC bias, the power is applied directly to the substrate holder.

An additional complication of reactive sputtering to form non-conductive films is that arcing from the target must be suppressed to prevent localized damage to the target, creating a particulate spray of target material which impacts the substrate.

Preferably, films prepared by the current process are comprised of materials selected from the group consisting of oxides of titanium, aluminum, silicon, tantalum, niobium; nitrides of silicon, and boron; and silicon carbide or mixtures thereof. However, those skilled in the art will understand the application of the subject process to a variety of dielectric materials. In fact, in certain instances it may be desirable to integrate metals such as aluminum or silver and semiconductors such as silicon into the dielectric films. Accordingly, the optical films may be comprised of multiple dielectric layers and non-dielectric material layers to enhance the film's performance.

Preferred inert gases included argon, krypton, and xenon. However, argon is particularly preferred due to its relative low cost. Preferred reactive gases include but are not limited to oxygen, nitrogen, and methane.

An apparatus for operating the above described process comprises a vacuum chamber equipped to maintain an atmosphere comprised of a reactive gas and an inert gas. Preferably, a rotatable substrate holder is positioned within the vacuum chamber. The vacuum chamber is equipped with at least two unbalanced DC magnetron sputtering devices, preferably positioned opposite one another with a linked magnetic field. Preferably, the targets comprise silicon and tantalum and the reactive gas is comprised of oxygen. The chamber is equipped with a means for controlling the level of reactive gas and a means to prevent arcing between the substrate and the sputtering cathode and/or target. Preferably, the means for sensing and controlling the reactive gas atmosphere is an optical gas controller or a quadruple mass analyzer. A suitable technique for controlling the atmosphere is described in U.S. Patent No. 4,428,811, herein incorporated by reference. This technique comprises introducing a continuous flow of reactive gas into the sputtering environment. The continuous flow rate is determined by monitoring the reactive gas partial pressure through a mass spectrometer. Based on the mass spectrometer reading, the flow of reactive gas is controlled by a mass flow meter. An MKS type 260 flow meter and a UTI (the Technology International) Model 100C mass spectrometer exemplify equipment appropriate for controlling the sputtering atmosphere.

The substrate holder and/or substrates are equipped with a means to apply an electrical bias relative to the plasma sufficient to form smooth film layers. In a preferred embodiment RF power is applied to the substrate holder through an impedance matching network, whereas in the case of a bi-polar pulsed DC bias, the power is applied directly to the substrate holder.

### Description of the Drawings

The invention consists in the novel parts, construction, arrangements, combinations and improvements shown and described. The accompanying drawings, which are incorporated in and constitute a part of the specification illustrate one embodiment of the invention and, together with the description, serve to explain the principles of the invention.

Of the drawings:
Figure 1 is a top view of the unbalanced DC magnetron sputtering apparatus;
Figure 2 is a photomicrograph of a multi-layer coating applied according to the present invention with an RF bias of minus 60 volts with respect to ground potential; and,
Figure 3 is a photomicrograph of a multi-layer coating prepared according to the present invention with an RF bias of minus 100 volts with respect to ground potential.

### Detailed Description of the Invention

Reference will now be made in detail to the present preferred embodiment of the invention, an example of which is illustrated in the accompanying drawings.

While the invention will be described in connection with a preferred procedure and apparatus, it will be understood that it is not intended to limit the invention to that procedure or apparatus. On the contrary, it is intended to cover all alternatives, modifications and equivalents which may be included within the spirit and scope of the invention defined by the appended claims.

The unbalanced DC magnetron sputtering process of this invention extends the sputtering plasma throughout the sputtering chamber and in combination with either a RF or a pulsed DC bias applied to the substrate, impart sufficient energy on the surface of the growing film to form high performance optical quality multi-layer films. The Unbalanced Magnetron: Current Status of Development; Münz, *Surface and Coating Technology*, *48 (1991) 81-94*, hereby incorporated by reference, fully describes an unbalanced DC magnetron system appropriate for use with the current invention.

As described therein, an unbalanced magnetron comprises a sputtering chamber housing a substrate mounted on a substrate holder. The magnetron is comprised of a target, inner and outer rows of rare earth magnets and two electromagnets to effect the unbalanced magnetic field which allows an increase in the plasma density in the region of the substrate. The increased plasma density is important in supplying sufficient ions which can be accelerated by the RF or bi-polar pulsed DC bias to effectively planarize the film surface and densify the film as it is being deposited. Unbalanced magnetron equipment suitable for this process is available from Hauzer Techno Coating Europe BV, for example, the HTC 1000-4 ABS and HTC 625 Multi lab ABS.

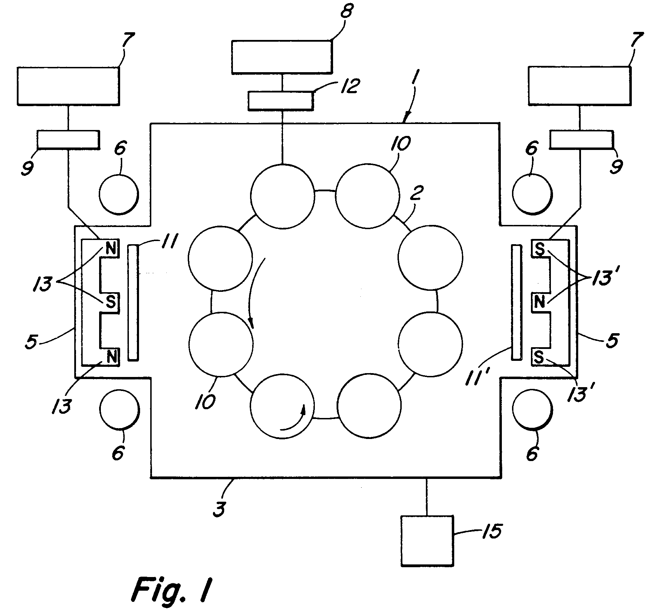

Referring now to Figure 1, wherein preferred sputtering assembly 1 for carrying out the process of the current invention is exemplified. The assembly 1 comprises a substrate holder 2 within vacuum chamber 3 and two unbalanced DC magnetron sputtering devices 5. DC power supplies 7 run through arc suppression units 9 and apply a modulated DC potential to the sputtering devices 5. Sputtering devices 5 are preferably placed on opposite sides of vacuum chamber 3 with substrate holder 2 placed centrally. To minimize cross contamination of the target, shuttering (not shown) of the targets during non-operational periods is performed.

An RF power supply 8, run through a matching network 12, is in electrical connection with the substrates 10 on substrate holder 2. The RF power supply and matching network is available from Advanced Energy, 1600 Prospect Parkway, Fort Collins, Colorado 80525. This assembly should have sufficient power to create a bias on the substrate of at least minus 200 volts.

Arc suppression device 9 is electrically connected between sputtering devices 5 and power supply 7. Device 9 is intended to suppress arcing from the target surface during sputtering. This has been found to be particularly necessary in reactive oxide sputtering of silicon. Preferably, a SPARC-LE unit available from Advanced Energy, 1600 Prospect Parkway, Fort Collins, Colorado 80525 is utilized. Optionally, a bi-polar pulsed DC power supply MAGPULS unit available from MAGTRON, Princeton Scientific Corp., P. O. Box 143, Princeton, New Jersey 08542 can be utilized. Each of these units function to suppress arcing on the sputtering targets during deposition using reactive gases.

Electromagnetic coils 6, target 11 and permanent magnets 13 make-up the unbalanced magnetron sputtering device 5. The magnets are aligned to create a distended plasma by trapping fast secondary electrons that escape from the primary magnetic trap near the target surface. These electrons then undergo ionizing collisions with gas atoms in the vicinity of the substrate. The electromagnetic coils 6 may alternatively be permanent magnets.

In a preferred system for coating halogen lamps, at least one target 11 is tantalum, preferably 99% pure, and more preferably 99.9% pure. The other target 11 is silicon, preferably at least 99.9% pure and more preferably 99.99% pure. The silicon target may be doped with small amounts of boron to increase its conductivity without negatively affecting the process.

Although the configuration, size, materials and other variables known to those skilled in the art determine the requisite system power, the sputtering device 5 of this embodiment having a 5" x 15" rectangular target is preferably powered in a range of from about 1 kilowatt to 10 kilowatts. The total pressure of the system is preferably from about 2.0 x 10⁻³ Torr to about 12 x 10⁻³ Torr, wherein the partial pressure of the reactive gas is between about 0.05 x 10⁻³ Torr and 1.0 x 10⁻³ Torr, with the remainder of the gas in the system being comprised of an inert gas. The partial pressure of the reactive gas is controlled throughout the reactive sputtering process by means of an optical gas controller 15, (such as INFICON OGC) or, alternately, a quadruple mass analyzer interfaced with a mass flow controller in a closed loop control scheme. Either unit is available from Leybold Inificon, Inc., East Syracuse, New York.

This gas control procedure is fully discussed in *Advances in Partial Pressure Control Applied to Reactive Sputtering*, W.D. Sproul, et al, Surface and Coatings Technology, 39/40 (1989), 499-506, herein incorporated by reference. This article describes the use of a quadruple mass analyzer which separates gases by mass ratio, and provides a unique signal for each. Alternatively, an optical gas controller which depends on electron emission spectroscopy to excite the gas and measure its photon emissions can be used for analysis of the sputtering chamber gas constituents. The optical gas controller is a self-contained partial pressure control system while the quadruple mass analyzer supplies a closed-loop control scheme.

One of ordinary skill in the art will recognize that the system configuration and sputter device power will determine the preferred rotational speeds of substrate holder 2. In this embodiment, the rpm is preferably in the range of about 20-25 rpm.

It is believed that preheating the substrates produces better films. Accordingly, auxiliary radiant heaters could be added to the system. In addition, it is believed that a plasma etching process used to clean the system before start-up of sputtering will clean the substrate surface to promote good adhesion of the film and will raise the temperature of the substrate.

### Examples

The following examples were performed in a sputtering system comprised of a laboratory built, dual-cathode, unbalanced magnetron sputtering system. The system included a stainless steel chamber, approximately 66 cm. in diameter by 70 cm. high, surrounded by a water jacket. Two DC power supplies provide power to two 12.7 cm by 38.1 cm. sputtering targets. An INFICON DGC from Leybold Inficon, Inc. was used to control the reactive gas environment and a 2KH_{z} SAPARC-LE unit from Advanced Energy was used to prevent arcing. The negatives bias was applied to the substrate using a RF bias feed through a matching network. W.D. Sproul, et al., Surface and Coatings Technology, 43/44 (1990) p. 270-278 herein incorporated by reference also describes the basic sputtering unit.

A first target was formed of 99.9% tantalum and the other was 99.9999% silicon doped with boron having a resistivity of less than 0.2 ohm cm. The targets faced one another across a vacuum chamber separated by approximately 11 inches. Substrates were mounted on a rotatable five inch diameter cylindrical table. Rotation speeds of 20-25 rpms were utilized. The targets were shuttered to expose substrates only when proper conditions were established, i.e. reactive gas partial pressure and target power. Once paper conditions were established one target was opened to expose the substrate to the sputtered material while the other target was shuttered to prevent contamination.

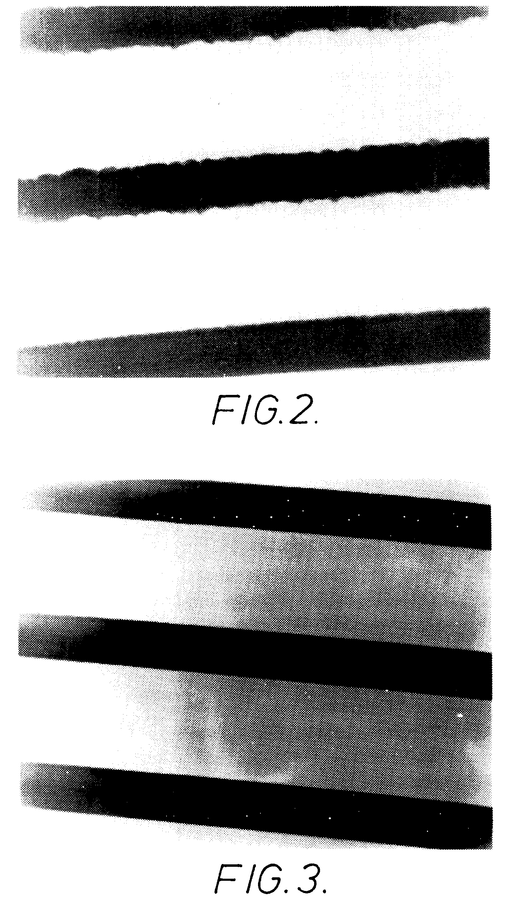

A 14 layer film (Figure 2) was prepared at 0₂ partial pressure of 0.64 x 10⁻⁴ Torr for silica deposition and 1.8 x 10⁻⁴ Torr for tantala deposition with a minus 60 volt bias applied to the substrate. The poor quality film of Figure 2 shows a variation of a layer surface of about 250 Angstom between the average plane of the peaks and average plane of the valleys with a lateral distance between peaks of 250 to 1000 Angstrom. A 12 layer film (Figure 3) was prepared at 0₂ partial pressure of 0.64 x 10⁻⁴ Torr for silica deposition and 1.8 x 10⁻⁴ Torr for tantala deposition using a minus 100 volt bias. The film surface of Figure 3 demonstrates a good quality film having variations of less than 100 Angstrom between the average peak plane and the average valley plane. For reference purposes, the area (generally lighter in color) between the tantala layers in Figures 2 and 3 is approximately 4,000 Angstrom thick. The photomicrographs establish that the higher RF bias significantly improves the quality of a multi-layer coating by reducing waviness, a critical flaw of prior processes which sputtered dielectric materials.

Without being bound by theory, we believe our system optimizes the effectiveness of the energy reaching the substrate coatings, overcoming the previously unrecognized problems of sputtered dielectric films which prevented their use in high performance optical applications. More particularly, the present system, creates a smooth, non-wavy multi-layer film. Furthermore, compressive stress on single layer films has been found to be between 300 and 600 MPa. In comparison, the CVD processes are known to suffer from undesirable tensile stress which is more likely to cause physical coating failures.

Thus, it is apparent that there has been provided in accordance with the invention, a process that fully satisfies the objects, aims and advantages set forth above. While the invention has been described in conjunction with specific embodiments thereof, it is evident that many alternatives, modifications, and variations will be apparent to those skilled in the art in light of the foregoing description. Accordingly, it is intended to embrace all such alternatives, modifications and variations as fall within the spirit and broad scope of the appended claims.

## Claims

1. A process for forming a multi-layer coating comprising unbalanced DC magnetron sputtering of a dielectric material onto a substrate having a negative electrical bias of at least minus sixty volts applied thereto, and maintaining a sputtering atmosphere comprised of an inert gas and a sufficient amount of a reactive gas to produce a stoichiometric compound on said substrate and less than an amount of reactive gas which substantially poisons said target.

2. A process for making a multi-layer film of at least two dielectric materials comprising:
(a) positioning a substrate in a vacuum chamber;
(b) maintaining an atmosphere comprised of an inert gas and a reactive gas;
(c) operating a first unbalanced DC magnetron sputtering device to deposit a first material onto said substrate while having a sufficient negative electric bias applied to said substrate to prevent waviness of individual layer surfaces;
(d) operating a second unbalanced DC magnetron sputtering device to deposit a second material onto said substrate while having a sufficient negative electric bias applied to said substrate to prevent waviness of individual layer surfaces; and
(e) repeating steps (b) through (d) until a desired thickness of film is achieved.

3. The process of claim 2, wherein said film has a transparency between about 400 and 750 nm of at least about 90% and a reflectance of at least about 70% between about 750 and 2000 nm.

4. The process of claim 2, wherein said materials are selected from the group consisting of tantalum oxide, titanium oxide, aluminum oxide, silicon oxide, niobium oxide, silicon nitride, boron nitride, silicon carbide and mixtures thereof.

5. The process of claim 2, wherein said reactive gas is selected from the group consisting of oxygen, nitrogen, methane, and mixtures thereof.

6. The process of claim 2, including the step of suppressing arcing from said sputtering devices during operation.

7. A process for making multi-layer films of at least two dielectric materials comprising:
(a) positioning a substrate in a vacuum chamber;
(b) maintaining an atmosphere comprised of an inert gas and a reactive gas sufficient to produce a desired composition in the film layers;
(c) operating a first unbalanced DC magnetron sputtering device to deposit a first material onto said substrate while applying at least minus 60 volt either bi-polar pulsed DC or RF electric bias to said substrate and suppressing arcing from said sputtering device;
(d) operating a second unbalanced DC magnetron sputtering device to deposit a second material onto said substrate while applying at least minus 60 volt either bi-polar pulsed DC or RF electric bias to said substrate and suppressing arcing from said sputtering device; and
(e) repeating steps (b) through (d) until a desired thickness of film is achieved.

8. A lamp envelope including a multi-layer infrared reflecting coating having at least an average 90 percent transmittance in a wavelength range of about 400 to 750 nm and at least 70 percent reflectance in a wavelength range of about 750 to 2000 nm, prepared according to the process of claim 7.

9. The lamp envelope of claim 8, wherein said coating comprises at least 50 layers having a thickness of greater than 4 microns.

10. An apparatus for sputter coating a multi-layer film comprised of dielectric materials onto a substrate, comprising:
a vacuum chamber for containing an inert gas and a reactive gas, at least two unbalanced DC magnetron sputtering devices including targets of dielectric material positioned to create a plasma in said chamber, an apparatus controlling the partial pressure of said reactive gas in said chamber, a device preventing arcing of said sputtering devices, and a device applying a negative electrical bias to said substrate sufficient to make said multi-layer film with a smooth interface between the layers.
